# EUROPÄISCHE PATENTSCHRIFT

(11) **EP 3 502 183 B1**
(45) Veröffentlichungstag und Bekanntmachung des Hinweises auf die Patenterteilung: **21.10.2020**
(21) Anmeldenummer: 17208726.4
(22) Anmeldetag: 20.12.2017
(51) Int. Cl.: C08L 69/00

(54) **TALK-GEFÜLLTE POLYCARBONAT-ZUSAMMENSETZUNGEN**
TALC-FILLED POLYCARBONATE COMPOSITIONS
COMPOSITIONS DE POLYCARBONATE CHARGÉES DE TALC

(43) Veröffentlichungstag der Anmeldung: 26.06.2019
(73) Patentinhaber: Covestro Deutschland AG, 51373 Leverkusen (DE)
(72) Erfinder: Die Erfindernennung liegt noch nicht vor
(74) Vertreter: Levpat

(56) Entgegenhaltungen:
- EP-A2- 0 332 454
- WO-A1-2010/108626
- WO-A1-2014/188609

## Beschreibung

Die vorliegende Erfindung betrifft die Stabilisierung von aromatischem Polycarbonat in Talk-haltigen Polycarbonatzusammensetzungen gegen den Molekulargewichtsabbau bei gleichzeitig möglichst geringer Beeinflussung der Wärmeformbeständigkeit und entsprechend die Verwendung eines neuen Additives zu diesem Zweck sowie entsprechende Zusammensetzungen, enthaltend aromatisches Polycarbonat und Talk und also auch ein Verfahren zur Vermeidung bzw. Reduzierung des Polycarbonat-Abbaus durch den Zusatz von Talk. Die Erfindung betrifft außerdem Formteile aus diesen Zusammensetzungen.

Aus der WO 2014/188609 A1 sind Zusammensetzungen umfassend unter anderem Polycarbonat, Polymethylmethacrylat und Talk bekannt. Die WO 2010/108626 A1 offenbart Zusammensetzungen enthaltend unter anderem Polycarbonat und PMMI.

Die Herstellung von gefüllten Polycarbonat-Zusammensetzungen durch Compoundierung führt unter Standard-Prozessbedingungen, je nach Füllstoff, zu einem Molekulargewichtsabbau des Polycarbonates. Dieser Effekt ist insbesondere bei Talk-haltigen Zusammensetzungen stark ausgeprägt, da dieser Füllstoff eine sehr hohe Zahl reaktiver Gruppen, etwa basische Hydroxylgruppen, an der Oberfläche trägt.

Der Molekulargewichtsabbau hat seinerseits einen negativen Einfluss auf die optischen, rheologischen, mechanischen und thermischen Eigenschaften der Polycarbonat-Zusammensetzungen. Es ist daher erforderlich, dass den Zusammensetzungen Prozessstabilisatoren zugesetzt werden, die den Abbau der Polymerketten, den Molekulargewichtsabbau, inhibieren.

Klassische Prozessstabilisatoren wie Phosphite oder Phosphonite haben sich als nicht geeignet erwiesen, um den Füllstoff-induzierten Abbau zu inhibieren. In gefüllten Thermoplasten kommen unter anderem oxidierte, Säure-modifizierte polyolefinische (Co)polymere, wie z.B. HiWax der Firma Mitsui Chemicals, oder A-C-Produkte der Firma Honeywell zum Einsatz. Die WO 2016/087477 A1 beschreibt den Einsatz von oxidierten Polyethylen-Wachsen in Polycarbonat und deren Einfluss, unter anderem auf die Wärmeformbeständigkeit. Bereits geringe Mengen dieser Additive können aufgrund ihrer niedrigen Schmelzpunkte die thermischen sowie mechanischen Eigenschaften herabsetzen. Zur Stabilisierung von gefüllten Polycarbonatzusammensetzungen sind, je nach Füllstoffgehalt, Wachskonzentrationen > 1 Gew.-% nötig. In höheren Konzentrationen haben solche Additive allerdings eine weichmachende Wirkung und schmälern dadurch die verstärkende Wirkung des Füllstoffes und somit dessen primäres Ziel. Zusätzlich nimmt die Mischbarkeit dieser olefinischen Wachse mit Polycarbonat mit steigendem Gehalt schnell ab, was zu einer starken Eintrübung der Compounds führt. Zudem wirkt sich dies auch bei Zugabe von Füllstoffen negativ auf die Einfärbbarkeit aus und führt zu Delaminationseffekten an der Oberfläche der Materialien. Des Weiteren ist die Stabilität solcher Wachse unter längerer thermischer Belastung nicht gegeben, was zu einer schnelleren Vergilbung des Materials führt.

Aufgabe war es daher, geeignete neuartige Stabilisatoren, die einen Molekulargewichtsabbau bei aromatischem Polycarbonat in Talk-gefüllten Polycarbonat-Zusammensetzungen inhibieren und sich dabei nicht negativ auf die eigentliche Verstärkungswirkung des Füllstoffes auswirken, zu identifizieren und entsprechende Zusammensetzungen bereitzustellen. Dabei sollten sich die thermischen, optischen und rheologischen Eigenschaften der Polycarbonat-Zusammensetzungen, vergleichen mit Zusammensetzungen ohne den neuartigen Stabilisator, möglichst wenig, am besten gar nicht negativ verändern.

Überraschend wird diese Aufgabe gelöst durch den Zusatz von PMMI-Copolymer zu den Polycarbonat-Zusammensetzungen. Durch den Zusatz des PMMI-Copolymers werden die Wärmeformbeständigkeit sowie die mechanischen und rheologischen Eigenschaften der PolycarbonatZusammensetzungen nicht signifikant verschlechtert, sondern in einigen Fällen sogar noch verbessert.

Gegenstand der Erfindung ist somit die Verwendung von PMMI-Copolymeren zur Inhibierung, d.h. mindestens Reduzierung, bevorzugt Vermeidung des Molekulargewichtsabbau von aromatischem Polycarbonat in Talk-gefüllten Polycarbonat-Zusammensetzungen beim Compoundieren, insbesondere auch beim Compoundieren mittels Ko-Kneter.

Compoundieren ist das Beimischen von Zuschlagstoffen, insbesondere von Füllstoffen und Additiven, zu dem Kunststoff, hier: zu dem aromatischen Polycarbonat. Dies geschieht üblicherweise mittels eines Extruders und bei Temperaturen im Extruder oberhalb von 260°C.

Gegenstand der Erfindung ist daher auch eine Zusammensetzung, enthaltend
A) aromatisches Polycarbonat,
B) Talk,
C) PMMI-Copolymer und
D) optional weitere Additive.

Die einzelnen Komponenten sind nachfolgend näher beschrieben.

### Komponente A

Komponente A der Zusammensetzungen sind aromatische Polycarbonate.

Aromatische Polycarbonate im Sinne der vorliegenden Erfindung sind sowohl Homopolycarbonate als auch Copolycarbonate und/oder Polyestercarbonate; die Polycarbonate können in bekannter Weise linear oder verzweigt sein. Erfindungsgemäß können auch Mischungen von Polycarbonaten verwendet werden.

Die thermoplastischen Polycarbonate einschließlich der thermoplastischen, aromatischen Polyestercarbonate haben bevorzugt gewichtsmittlere Molekulargewichte M_{w} von 15.000 g/mol bis 40.000 g/mol, weiter bevorzugt bis 34.000 g/mol, besonders bevorzugt von 17.000 g/mol bis 33.000 g/mol, insbesondere von 19.000 g/mol bis 32.000 g/mol, ermittelt durch Gelpermeationschromotographie, kalibriert gegen Bisphenol A-Polycarbonat Standards unter Verwendung von Dichlormethan als Elutionsmittel, Kalibrierung mit linearen Polycarbonaten (aus Bisphenol A und Phosgen) bekannter Molmassenverteilung der PSS Polymer Standards Service GmbH, Deutschland, Kalibrierung nach der Methode 2301-0257502-09D (aus dem Jahre 2009 in deutscher Sprache) der Currenta GmbH & Co. OHG, Leverkusen. Das Elutionsmittel ist Dichlormethan. Säulenkombination aus vernetzten Styrol-Divinylbenzolharzen. Durchmesser der analytischen Säulen: 7,5 mm; Länge: 300 mm. Partikelgrößen des Säulenmaterials: 3 µm bis 20 µm. Konzentration der Lösungen: 0,2 Gew.-%. Flussrate: 1,0 ml/min, Temperatur der Lösungen: 30°C. Verwendung einer UV- und/oder RI-Detektion.

Ein Teil, bis zu 80 Mol-%, vorzugsweise von 20 Mol-% bis zu 50 Mol-%, der Carbonat-Gruppen in den erfindungsgemäß eingesetzten Polycarbonaten können durch aromatische Dicarbonsäureester-Gruppen ersetzt sein. Derartige Polycarbonate, die sowohl Säurereste der Kohlensäure als auch Säurereste von aromatischen Dicarbonsäuren in die Molekülkette eingebaut enthalten, werden als aromatische Polyestercarbonate bezeichnet. Sie werden im Rahmen der vorliegenden Erfindung unter dem Oberbegriff der thermoplastischen, aromatischen Polycarbonate subsumiert.

Die Herstellung der Polycarbonate erfolgt in bekannter Weise aus Dihydroxyarylverbindungen, Kohlensäurederivaten, gegebenenfalls Kettenabbrechern und gegebenenfalls Verzweigern, wobei zur Herstellung der Polyestercarbonate ein Teil der Kohlensäurederivate durch aromatische Dicarbonsäuren oder Derivate der Dicarbonsäuren ersetzt wird, und zwar je nach Maßgabe der in den aromatischen Polycarbonaten zu ersetzenden Carbonatstruktureinheiten durch aromatische Dicarbonsäureesterstruktureinheiten.

Für die Herstellung von Polycarbonaten geeignete Dihydroxyarylverbindungen sind solche der Formel (1)

HO-Z-OH (1),

in welcher
Z ein aromatischer Rest mit 6 bis 30 C-Atomen ist, der einen oder mehrere aromatische Kerne enthalten kann, substituiert sein kann und aliphatische oder cycloaliphatische Reste bzw. Alkylaryle oder Heteroatome als Brückenglieder enthalten kann.

Bevorzugt steht Z in Formel (1) für einen Rest der Formel (2) 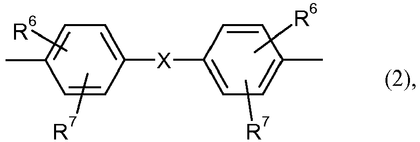 in der
- R⁶ und R⁷: unabhängig voneinander für H, C₁- bis C₁₈-Alkyl-, C₁- bis C₁₈-Alkoxy, Halogen wie Cl oder Br oder für jeweils gegebenenfalls substituiertes Aryl- oder Aralkyl, bevorzugt für H oder C₁- bis C₁₂-Alkyl, besonders bevorzugt für H oder C₁- bis C₈-Alkyl und ganz besonders bevorzugt für H oder Methyl stehen, und
- X: für eine Einfachbindung, -SO₂-, -CO-, -O-, -S-, C₁- bis C₆-Alkylen, C₂- bis C₅-Alkyliden oder C₅- bis C₆-Cycloalkyliden, welches mit C₁- bis C₆-Alkyl, vorzugsweise Methyl oder Ethyl, substituiert sein kann, ferner für C₆- bis C₁₂-Arylen, welches gegebenenfalls mit weiteren Heteroatome enthaltenden aromatischen Ringen kondensiert sein kann, steht.

Bevorzugt steht X für eine Einfachbindung, C₁- bis C₅-Alkylen, C₂- bis C₅-Alkyliden, C₅- bis C₆-Cycloalkyliden, -O-, -SO-, -CO-, -S-, -SO₂-
oder für einen Rest der Formel (3)

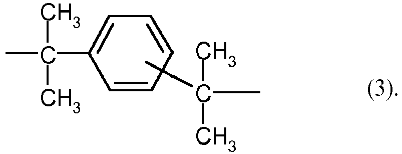

Beispiele für Dihydroxyarylverbindungen (Diphenole) sind: Dihydroxybenzole, Dihydroxydiphenyle, Bis-(hydroxyphenyl)-alkane, Bis-(hydroxyphenyl)-cycloalkane, Bis-(hydroxyphenyl)-aryle, Bis-(hydroxyphenyl)-ether, Bis-(hydroxyphenyl)-ketone, Bis-(hydroxyphenyl)-sulfide, Bis-(hydroxyphenyl)-sulfone, Bis-(hydroxyphenyl)-sulfoxide, 1,1'-Bis-(hydroxyphenyl)-diisopropylbenzole sowie deren kernalkylierte und kernhalogenierte Verbindungen.

Für die Herstellung der erfindungsgemäß zu verwendenden Polycarbonate und Copolycarbonate geeignete Dihydroxyarylverbindungen sind beispielsweise Hydrochinon, Resorcin, Dihydroxydiphenyl, Bis-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, a,a'-Bis-(hydroxyphenyl)-diisopropylbenzole sowie deren alkylierte, kernalkylierte und kernhalogenierte Verbindungen. Zur Herstellung von Copolycarbonaten können auch Si-haltige Telechele eingesetzt werden, sodass sogenannte Si-Copolycarbonate erhalten werden.

Bevorzugte Dihydroxyarylverbindungen sind 4,4'-Dihydroxydiphenyl, 2,2-Bis-(4-hydroxyphenyl)-1-phenylpropan, 1,1-Bis-(4-hydroxyphenyl)-phenylethan, 2,2-Bis-(4-hydroxyphenyl)propan, 2,4-Bis-(4-hydroxyphenyl)-2-methylbutan, 1,3-Bis-[2-(4-hydroxyphenyl)-2-propyl]benzol (Bisphenol M), 2,2-Bis-(3-methyl-4-hydroxyphenyl)-propan, Bis-(3,5-dimethyl-4-hydroxyphenyl)-methan, 2,2-Bis-(3,5-dimethyl-4-hydroxyphenyl)-propn, Bis-(3,5-dimethyl-4-hydroxyphenyl)-sulfon, 2,4-Bis-(3,5-dimethyl-4-hydroxyphenyl)-2-methylbutan, 1,3-Bis-[2-(3,5-dimethyl-4-hydroxyphenyl)-2-propyl]-benzol und 1,1-Bis-(4-hydroxyphenyl)-3,3,5-triamethylcyclohexan (Bisphenol TMC) sowie die Bisphenole der Formeln (I) bis (III) 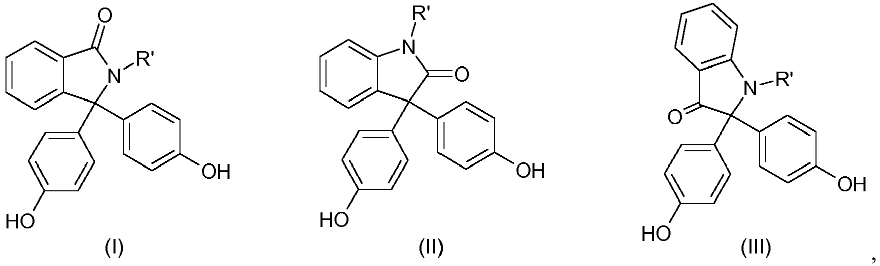 in denen R' jeweils für einen C₁- bis C₄-Alkylrest, Aralkylrest oder Arylrest, bevorzugt für einen Methylrest oder Phenylrest, ganz besonders bevorzugt für einen Methylrest, steht.

Besonders bevorzugte Dihydroxyarylverbindungen sind 4,4'-Dihydroxydiphenyl, 1,1-Bis-(4-hydroxyphenyl)-phenyl-ethan, 2,2-Bis-(4-hydroxyphenyl)-propan, 2,2-Bis(3,5-dimethyl-4-hydroxyphenyl)-propan, 1,1-Bis-(4-hydroxyphenyl)-cyclohexan und 1,1-Bis-(4-hydroxyphenyl)-3,3,5-trimethylcyclohexan (Bisphenol TMC) sowie die Dihydroxyarylverbindungen der Formeln (I), (II) und/oder (III).

Diese und weitere geeignete Dihydroxyarylverbindungen sind z.B. in US 2 999 835 A, 3 148 172 A, 2 991 273 A, 3 271 367 A, 4 982 014 A und 2 999 846 A, in den deutschen Offenlegungsschriften 1 570 703 A, 2 063 050 A, 2 036 052 A, 2 211 956 A und 3 832 396 A, der französischen Patentschrift 1 561 518 A1, in der Monographie "H. Schnell, Chemistry and Physics of Polycarbonates, Interscience Publishers, New York 1964, S. 28 ff.; S.102 ff", und in "D.G. Legrand, J.T. Bendler, Handbook of Polycarbonate Science and Technology, Marcel Dekker New York 2000, S. 72ff." beschrieben.

Im Falle der Homopolycarbonate wird nur eine Dihydroxyarylverbindung eingesetzt, im Falle von Copolycarbonaten werden zwei oder mehr Dihydroxyarylverbindungen eingesetzt.

Besonders bevorzugte Polycarbonate sind das Homopolycarbonat auf Basis von Bisphenol A, das Homopolycarbonat auf Basis von 1,1-Bis-(4-hydroxyphenyl)-3,3,5-trimethylcyclohexan und die Copolycarbonate auf Basis der beiden Monomere Bisphenol A und 1,1-Bis-(4-hydroxyphenyl)-3,3,5-trimethylcyclohexan beziehungsweise der beiden Monomere Bisphenol A und 4,4'-Dihydroxydiphenyl, sowie von den Dihydroxyarylverbindungen der Formeln (I), (II) und/oder (III) 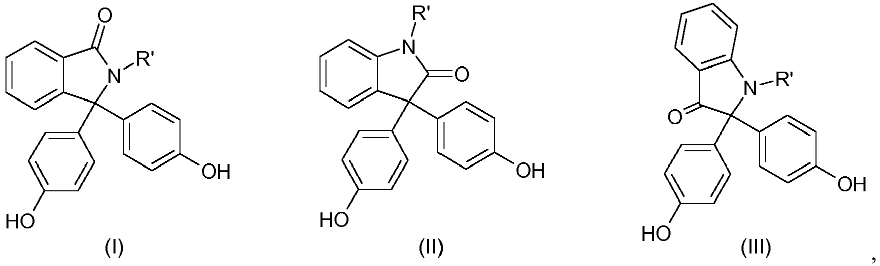 in denen R' jeweils für C₁- bis C₄-Alkyl, Aralkyl oder Aryl, bevorzugt für Methyl oder Phenyl, ganz besonders bevorzugt für Methyl, steht,
abgeleitete Homo- oder Copolycarbonate, insbesondere mit Bisphenol A.

Die verwendeten Dihydroxyarylverbindungen, wie auch alle anderen der Synthese zugesetzten Chemikalien und Hilfsstoffe, können mit den aus ihrer eigenen Synthese, Handhabung und Lagerung stammenden Verunreinigungen kontaminiert sein. Es ist jedoch wünschenswert, mit möglichst reinen Rohstoffen zu arbeiten.

Bevorzugt sind auch Copolycarbonate mit einer oder mehreren Monomereinheiten eines Siloxans der allgemeinen Formel (IV) 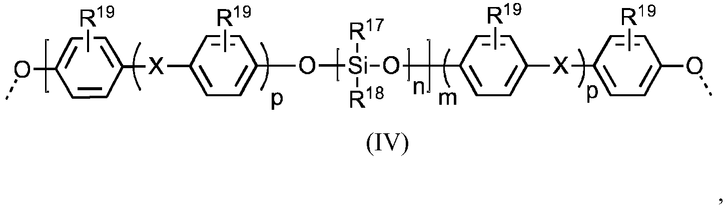 in der
R¹⁹ für Wasserstoff, Cl, Br oder einen C₁- bis C₄-Alkylrest, vorzugsweise für Wasserstoff oder einen Methylrest, besonders bevorzugt für Wasserstoff, steht,
R¹⁷ und R¹⁸ gleich oder verschieden sind und unabhängig voneinander für einen Arylrest, einen C₁-bis C₁₀-Alkylrest oder einen C₁- bis C₁₀-Alkylarylrest, bevorzugt jeweils für einen Methylrest, stehen und wobei
X eine Einfachbindung, -CO-, -O-, ein C₁- bis C₆-Alkylenrest, ein C₂- bis Cs-Alkylidenrest, ein C₅-bis C₁₂-Cycloalkylidenrest oder ein C₆- bis C₁₂-Arylenrest ist, der optional mit weiteren aromatischen Ringen kondensiert sein kann, welche Heteroatome enthalten, wobei X bevorzugt eine Einfachbindung, ein C₁- bis Cs-Alkylenrest, ein C₂- bis C₅-Alkylidenrest, ein C₅- bis C₁₂-Cycloalkylidenrest, -O- oder -CO- ist, weiter bevorzugt eine Einfachbindung, ein Isopropylidenrest, ein C₅- bis C₁₂-Cycloalkylidenrest oder -O- ist, ganz besonders bevorzugt ein Isopropylidenrest, ist,
n eine Zahl von 1 bis 500, vorzugsweise von 10 bis 400, besonders bevorzugt von 10 bis 100, ganz besonders bevorzugt von 20 bis 60, ist,
m eine Zahl von 1 bis 10, bevorzugt von 1 bis 6, besonders bevorzugt von 2 bis 5, ist,
p 0 oder 1, bevorzugt 1, ist,
und der Wert von n mal m vorzugsweise zwischen 12 und 400, weiter bevorzugt zwischen 15 und 200 liegt,
wobei das Siloxan bevorzugt mit einem Polycarbonat in Gegenwart eines organischen oder anorganischen Salzes einer schwachen Säure mit einem pK_{A} Wert von 3 bis 7 (25°C) umgesetzt wird.

Copolycarbonate mit Monomereinheiten der Formel (IV) und insbesondere auch deren Herstellung sind in der WO 2015/052106 A2 beschrieben.

Der Gesamtanteil der Monomereinheiten beruhend auf den Formeln (I), (II), (III), 4,4'-Dihydroxydiphenyl und/oder Bisphenol TMC im Copolycarbonat beträgt vorzugsweise 0,1 - 88 mol-%, besonders bevorzugt 1 - 86 mol-%, ganz besonders bevorzugt 5 - 84 mol-% und insbesondere 10 - 82 mol-% (bezogen auf die Summe der Mole eingesetzter Dihydroxyarylverbindungen).

Die Copolycarbonate können als block- und statistisches Copolycarbonat vorliegen. Besonders bevorzugt sind statistische Copolycarbonate.

Dabei ergibt sich das Verhältnis der Häufigkeit der Diphenolat-Monomereinheiten im Copolycarbonat aus dem Molverhältnis der eingesetzten Dihydroxyarylverbindungen.

Die relative Lösungsviskosität der Copolycarbonate, bestimmt nach ISO 1628-4:1999, liegt bevorzugt im Bereich von = 1,15 - 1,35.

Die zur Regelung des Molekulargewichtes benötigten monofunktionellen Kettenabbrecher, wie Phenole oder Alkylphenole, insbesondere Phenol, p-tert. Butylphenol, iso-Octylphenol, Cumylphenol, deren Chlorkohlensäureester oder Säurechloride von Monocarbonsäuren bzw. Gemische aus diesen Kettenabbrechern, werden entweder mit dem Bisphenolat bzw. den Bisphenolaten der Reaktion zugeführt oder aber zu jedem beliebigen Zeitpunkt der Synthese zugesetzt, solange im Reaktionsgemisch noch Phosgen oder Chlorkohlensäureendgruppen vorhanden sind, bzw. im Falle der Säurechloride und Chlorkohlensäureester als Kettenabbrecher, solange genügend phenolische Endgruppen des sich bildenden Polymers zur Verfügung stehen. Vorzugsweise werden der oder die Kettenabbrecher jedoch nach der Phosgenierung an einem Ort oder zu einem Zeitpunkt zugegeben, wenn kein Phosgen mehr vorliegt, aber der Katalysator noch nicht dosiert wurde, bzw. sie werden vor dem Katalysator, mit dem Katalysator zusammen oder parallel zudosiert.

In der gleichen Weise werden eventuell zu verwendende Verzweiger oder Verzweigermischungen der Synthese zugesetzt, üblicherweise jedoch vor den Kettenabbrechern. Üblicherweise werden Trisphenole, Quarterphenole oder Säurechloride von Tri- oder Tetracarbonsäuren verwendet oder auch Gemische der Polyphenole oder der Säurechloride.

Einige der als Verzweiger verwendbaren Verbindungen mit drei oder mehr als drei phenolischen Hydroxylgruppen sind beispielsweise Phloroglucin, 4,6-Dimethyl-2,4,6-tri-(4-hydroxyphenyl)-hepten-2, 4,6-Dimethyl-2,4,6-tri-(4-hydroxyphenyl)-heptan, 1,3,5-Tris-(4-hydroxyphenyl)-benzol, 1,1,1-Tri-(4-hydroxyphenyl)-ethan, Tris-(4-hydroxyphenyl)-phenylmethan, 2,2-Bis-[4,4-bis-(4-hydroxyphenyl)-cyclohexyl] -propan, 2,4-Bis-(4-hydroxyphenyl-isopropyl)-phenol, Tetra-(4-hydroxyphenyl)-methan.

Einige der sonstigen trifunktionellen Verbindungen sind 2,4-Dihydroxybenzoesäure, Trimesinsäure, Cyanurchlorid und 3,3-Bis-(3-methyl-4-hydroxyphenyl)-2-oxo-2,3-dihydroindol.

Bevorzugte Verzweiger sind 3,3-Bis-(3-methyl-4-hydroxyphenyl)-2-oxo-2,3-dihydroindol und 1,1,1-Tri-(4-hydroxyphenyl)-ethan.

Die Menge der gegebenenfalls einzusetzenden Verzweiger beträgt 0,05 Mol-% bis 2 Mol-%, bezogen wiederum auf Mole an jeweils eingesetzten Diphenolen.

Die Verzweiger können entweder mit den Diphenolen und den Kettenabbrechern in der wässrigen alkalischen Phase vorgelegt werden oder in einem organischen Lösungsmittel gelöst vor der Phosgenierung zugegeben werden.

Alle diese Maßnahmen zur Herstellung der Polycarbonate sind dem Fachmann geläufig.

Für die Herstellung der Polyestercarbonate geeignete aromatische Dicarbonsäuren sind beispielsweise Orthophthalsäure, Terephthalsäure, Isophthalsäure, tert-Butylisophthalsäure, 3,3'-Diphenyldicarbonsäure, 4,4'-Diphenyldicarbonsäure, 4,4-Benzophenondicarbonsäure, 3,4'-Benzophenondicarbonsäure, 4,4'-Diphenyletherdicarbonsäure, 4,4'-Diphenylsulfondicarbonsäure, 2,2-Bis-(4-carboxyphenyl)-propan, Trimethyl-3-phenylindan-4,5'-dicarbonsäure.

Von den aromatischen Dicarbonsäuren werden besonders bevorzugt die Terephthalsäure und/oder Isophthalsäure eingesetzt.

Derivate der Dicarbonsäuren sind die Dicarbonsäuredihalogenide und die Dicarbonsäuredialkylester, insbesondere die Dicarbonsäuredichloride und die Dicarbonsäuredimethylester.

Der Ersatz der Carbonatgruppen durch die aromatischen Dicarbonsäureestergruppen erfolgt im Wesentlichen stöchiometrisch und auch quantitativ, so dass das molare Verhältnis der Reaktionspartner sich auch im fertigen Polyestercarbonat wiederfindet. Der Einbau der aromatischen Dicarbonsäureestergruppen kann sowohl statistisch als auch blockweise erfolgen.

Bevorzugte Herstellungsweisen der erfindungsgemäß zu verwendenden Polycarbonate, einschließlich der Polyestercarbonate, sind das bekannte Grenzflächenverfahren und das bekannte Schmelzeumesterungsverfahren (vgl. z. B. WO 2004/063249 A1, WO 2001/05866 A1, US 5,340,905 A, US 5,097,002 A, US-A 5,717,057 A).

Im ersten Fall dienen als Säurederivate vorzugsweise Phosgen und gegebenenfalls Dicarbonsäuredichloride, im letzteren Fall vorzugsweise Diphenylcarbonat und gegebenenfalls Dicarbonsäurediester. Katalysatoren, Lösungsmittel, Aufarbeitung, Reaktionsbedingungen etc. für die Polycarbonatherstellung bzw. Polyestercarbonatherstellung sind in beiden Fällen hinreichend beschrieben und bekannt.

Zusammensetzungen i.S. der Erfindung sind bevorzugt "Polycarbonat-Zusammensetzungen" oder auch auf "Polycarbonat basierende Zusammensetzungen". Dieses sind solche Zusammensetzungen, deren Basismaterial, d.h. überwiegend vorhandene Komponente, ein Polycarbonat ist. "Überwiegend" bedeutet hierbei mindestens 60 Gew.-%, bevorzugt mindestens 68 Gew.-%, weiter bevorzugt mindestens 70 Gew.-%, besonders bevorzugt mindestens 74 Gew.-%, aromatisches Polycarbonat, bezogen auf die Gesamtzusammensetzung.

### Komponente B

Erfindungsgemäß wird als Komponente B) beschlichteter oder unbeschlichteter Talk verwendet. Unbeschlichteter Talk ist erfindungsgemäß solcher, der vor der Vermischung mit einer weiteren Komponente keine Schlichte aufweist. Der Einsatz der PMMI-Copolymere ist insbesondere bei Zusammensetzungen bevorzugt, bei denen unbeschlichteter Talk eingesetzt wird.

Talk im Sinne der vorliegenden Erfindung ist bevorzugt ein Talk, welcher im Wesentlichen die gleiche chemische Zusammensetzung, Partikeldurchmesser, Porosität und/oder BET-Oberfläche aufweist, oder ein Talkgemisch.

Bei Talk handelt es sich im Allgemeinen um ein Schichtsilikat. Es kann beschrieben werden als Magnesiumsilikathydrat mit der allgemeinen chemischen Zusammensetzung Mg₃[Si₄O₁₀(OH)₂]. Unterschiedliche Talkarten enthalten jedoch unterschiedliche Verunreinigungen, so dass Abweichungen von dieser allgemeinen Zusammensetzung vorliegen können.

Der Talk kann eine Schlichte aufweisen, um die Verträglichkeit mit dem Polymer zu verbessern. Im Sinne der vorliegenden Erfindung wird eine Schlichte als eine gezielte (chemi- oder physisorbierte) Anreicherung von Molekülen unterschiedlich von Talkum, insbesondere Mg₃[Si₄O₁₀(OH)₂], an der Oberfläche betrachtet. Bei unbeschlichtetem Talk handelt es sich somit um nicht oberflächen-behandelten Talk, d. h. nach der Gewinnung der Talkpartikel mit dem gewünschten Partikeldurchmesser und gegebenenfalls einer Kompaktierung wurde der Talk bevorzugt keinem weiteren Verfahrensschritt unterzogen, welcher die Oberfläche des Talks durch Chemisorption oder Physisorption gezielt verändert. Dies schließt jedoch nicht aus, dass unbeabsichtigt Verunreinigungen, Staub oder ähnliche Partikel während der weiteren Handhabung des Talks an Teile der Oberfläche gelangen, solange die Oberfläche des Talks nicht wesentlich ihre Eigenschaften, insbesondere in Bezug auf den pH-Wert, verliert.

Bevorzugt weist der Talk einen pH-Wert von 8 bis 10, besonders bevorzugt 8,5 bis 9,8, ganz besonders bevorzugt 9,0 bis 9,7 auf, wobei der pH-Wert bestimmt wird gemäß EN ISO 787-9:1995. Es ist zu beachten, dass die EN ISO 787-9:1995 auch die Möglichkeit der Zugabe von Ethanol oder anderen organischen Lösungsmitteln zur Verbesserung der Dispergierung des zu vermessenden Feststoffes erwähnt. Bevorzugt wird erfindungsgemäß nur destilliertes Wasser zur Bestimmung des pH-Wertes gemäß EN ISO 787-9:1995 eingesetzt.

Die Komponente B) weist bevorzugt einen Gehalt an Eisen(II)oxid und/oder Eisen(III)oxid von 0,2 bis 2,5 Gew.-%, besonders bevorzugt 0,3 bis 2,3 Gew.-%, ganz besonders bevorzugt von 0,3 bis 2,0 Gew.-% auf. Dieser Gehalt wird bevorzugt gemessen durch Röntgenfluoreszenz oder Atomabsorptionsspektroskopie. Es hat sich herausgestellt, dass der Gehalt an Eisenoxid im Talk einen Einfluss auf den Grad des Abbau des Polycarbonats aufweist. Im erfindungsgemäß angegebenen Gehaltsbereich an Eisenoxid wurden besonders gute Ergebnisse in Bezug auf die Verminderung des Abbaus des Polycarbonats erzielt.

Ebenso bevorzugt weist die Komponente B) einen Gehalt an Aluminiumoxid von 0,01 bis 0,5 Gew.-%, besonders bevorzugt von 0,05 bis 0,48 Gew.-%, ganz besonders bevorzugt von 0,15 bis 0,45 Gew.-% auf.

Die Komponente B) weist bevorzugt einen mittleren Partikeldurchmesser D₅₀ von 0,01 bis 9,5 µm auf, besonders bevorzugt 0,25 bis 8,00 µm, weiterhin bevorzugt 0,5 bis 6,00 µm und ganz besonders bevorzugt 0,6 µm bis kleiner oder gleich 3,0 µm auf, wobei der Partikeldurchmesser D₅₀ bestimmt wird durch Sedimentationsanalyse. Unter dem Mittelwert D₅₀ versteht der Fachmann einen mittleren Partikeldurchmesser, bei dem 50 % der Partikel kleiner sind als der definierte Wert. Bevorzugt wird der Partikeldurchmesser D₅₀ bestimmt gemäß ISO13317-3:2001.

Komponente B) weist bevorzugt eine BET-Oberfläche von 7,5 bis 20,0 m²/g, besonders bevorzugt von 9,0 bis 15,0 m²/g, ganz besonders bevorzugt 9,5 bis 14,0 m²/g auf. Die Bestimmung der Oberfläche nach Brunauer, Emmett und Teller mittels Gasadsorption ist dem Fachmann an sich bekannt. Bevorzugt wird die BET-Oberfläche gemäß ISO 4652:2012 bestimmt. Diese bevorzugte BET-Oberfläche wird besonders bevorzugt mit dem oben beschriebenen mittleren Partikeldurchmesser D₅₀ des Talks verbunden.

Besonders bevorzugt weist der Talk einen Talkgehalt von ≥ 96 Gew.-%, besonders bevorzugt ≥ 97 Gew.-%, ganz besonders bevorzugt ≥ 98 Gew.-% auf.

Ebenso ist es bevorzugt, dass der Talk einen Glühverlust bei 1050 °C von 5,0 bis 7,0 Gew.-%, besonders bevorzugt von 5,2 bis 6,5 Gew.-% und ganz besonders bevorzugt von 5,3 bis 6,2 Gew.-% aufweist. Der Glühverlust wird bevorzugt mittels DIN51081:2002 bestimmt.

Der Talk oder das Talkgemisch gemäß Komponente B) liegt bevorzugt kompaktiert vor.

### Komponente C

Komponente C sind PMMI-Copolymere. Dieses sind thermoplastische Kunststoffe, welche teilweise imidierte Methacrylpolymerisate sind. PMMI-Copolymere werden insbesondere erhalten durch Umsetzung von PMMA mit Methylamin in Dispersion oder in der Schmelze in einem Reaktor. Ein geeignetes Verfahren ist beispielsweise in DE 1 077 872 A1 beschrieben. Dabei werden entlang der Polymerkette Imidstrukturen erzeugt, wobei, je nach Umsetzungsgrad, auch noch Methacrylsäureanhydrid- und freie Methacrylsäure-Funktionalitäten gebildet werden. Der Anteil an Imidfunktionalitäten im Copolymer bestimmt dessen Wärmeformbeständigkeit. Der Umsetzungsgrad ist gezielt einstellbar.

PMMI-Copolymere weisen Methylmethacrylat- (MMA, 4a), Methylmethacrylimid- (MMI, 6), Methylmethacrylsäure- (MMS, 4b) und Methylmethacrylanhydrid-Einheiten (MMAH, 5) auf. Bevorzugt sind mindestens 90, weiter bevorzugt mindestens 95 Gew.-% des PMMI-Copolymers, bezogen auf das Gesamtgewicht des PMMI-Copolymers, MMA-, MMI-, MMS- und MMAH-Einheiten. Besonders bevorzugt bestehen die PMMI-Copolymere aus diesen Bausteinen.

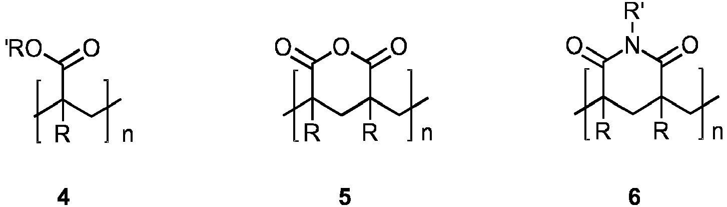

MMA: 4a (R=R'=CH₃), MMS: 4b (R=CH₃, R'=H), MMAH: 5 (R=CH₃), MMI: 6 ((R=R'=CH₃).

Die Bausteine und deren Anteile am PMMI-Copolymer können insbesondere mittels quantitativer ¹H-NMR-Spektroskopie, anhand eindeutiger chemischer Verschiebung der R'-Signale, ermittelt werden. Die Aufschlüsselung der Signale der Säure- und Anhydrid-Monomerbausteine ist nicht eindeutig möglich, weshalb eine zusammengefasste Betrachtung dieser Bausteine zu empfehlen ist.

Das PMMI-Copolymer hat bevorzugt einen MMI-Anteil von mindestens 30 Gew.-%, bevorzugt von mindestens 35 Gew.-%, weiter bevorzugt von 35 bis 96 Gew.-%, besonders bevorzugt von 36 bis 95 Gew.-% MMI, bezogen auf das Gesamtgewicht des PMMI-Copolymers.

Der MMA-Anteil des Copolymers beträgt bevorzugt 3 bis 65 Gew.-%, bevorzugt 4 bis 60 Gew.-%, besonders bevorzugt 4,0 bis 55 Gew.-%, bezogen auf das Gesamtgewicht des PMMI-Copolymers.

Der Anteil an MMS und MMAH beträgt in Summe bevorzugt bis zu 15 Gew.-%, weiter bevorzugt bis zu 12 Gew.-%, besonders bevorzugt 0,5 bis 12 Gew.-%, bezogen auf das Gesamtgewicht des PMMI-Copolymers.

Die Säurezahl der PMMI-Copolymere, bestimmt nach DIN 53240-1:2013-06, beträgt bevorzugt 15 bis 50 mg KOH/g, weiter bevorzugt 20 bis 45 mg KOH/g, noch weiter bevorzugt 22 bis 42 mg KOH/g.

Ein ganz besonders bevorzugtes PMMI-Copolymer hat einen MMI-Anteil von 36,8 Gew.-%, einen MMA-Anteil von 51,7 Gew.-% und einen MMS+MMAH-Anteil von 11,5 Gew.-%, jeweils bezogen auf das Gesamtgewicht des PMMI-Copolymers, bestimmt mittels ¹H-NMR-Spektroskopie, und eine Säurezahl von 22,5 mg KOH/g, bestimmt nach DIN 53240-1:2013-06.

Ein alternativ ganz besonders bevorzugtes PMMI-Copolymer hat einen MMI-Anteil von 83,1 Gew.-%, einen MMA-Anteil von 13,6 Gew.-% und einen MMS+MMAH-Anteil von 3,3 Gew.-%, jeweils bezogen auf das Gesamtgewicht des PMMI-Copolymers, bestimmt mittels ¹H-NMR-Spektroskopie, und eine Säurezahl von 22,5 mg KOH/g, bestimmt nach DIN 53240-1:2013-06.

Ein ebenfalls alternativ ganz besonders bevorzugtes PMMI-Copolymer hat einen MMI-Anteil von 94,8 Gew.-%, einen MMA-Anteil von 4,6 Gew.-% und einen MMS+MMAH-Anteil von 0,6 Gew.-%, jeweils bezogen auf das Gesamtgewicht des PMMI-Copolymers, bestimmt mittels ¹H-NMR-Spektroskopie, und eine Säurezahl von 41,5 mg KOH/g, bestimmt nach DIN 53240-1:2013-06.

Geeignetes PMMI ist beispielsweise bei der Firma Evonik Industries AG unter der Marke "PLEXIMID®" erhältlich.

In den Talk-haltigen Polycarbonat-Zusammensetzungen beträgt die Zugabemenge für das PMMI-Copolymer bevorzugt mindestens 1,5 Gew.-%, weiter bevorzugt mindestens 2 Gew.-%, noch weiter bevorzugt mindestens 3 Gew.-%, besonders bevorzugt 4 Gew.-%, ganz besonders bevorzugt bis 6 Gew.-%, jeweils bezogen auf das Gesamtgewicht der Polycarbonat-Zusammensetzung.

Die Glastemperatur des PMMI-Copolymers beträgt bevorzugt 130 bis 170°C Damit ist das PMMI-Copolymer unter den für Polycarbonat - einschließlich den für hochtemperaturstabilen Polycarbonat-Copolymeren- üblichen Verarbeitungsbedingungen stabil.

### Komponente D

Die erfindungsgemäßen Zusammensetzungen können ein oder mehrere weitere Additive enthalten, welche vorliegend unter "Komponente D" zusammengefasst sind.

Die Additive sind optional (0 Gew.-%) bevorzugt bis zu 20,0 Gew.-%, weiter bevorzugt bis zu 10,0 Gew.-%, noch weiter bevorzugt zu 0,10 bis 8,0 Gew.-%, besonders bevorzugt zu 0,2 bis 3,0 Gew.-% in der erfindungsgemäßen Zusammensetzung enthalten, wobei sich diese Gewichtsprozente auf das Gesamtgewicht der Zusammensetzung beziehen.

Solche Additive, wie sie üblicherweise Polycarbonaten zugesetzt werden, sind beispielsweise in EP 0 839 623 A1, WO 96/15102 A2, EP 0 500 496 A1 oder im "Plastics Additives Handbook", Hans Zweifel, 5th Edition 2000, Hanser Verlag, München beschrieben. Geeignete Additive sind insbesondere Flammschutzmittel, Antitropfmittel, Schlagzähmodifikatoren, von Komponente B verschiedene Füllstoffe, Antistatika, organische und anorganische Farbmittel einschließlich Pigmenten und Ruß, Gleit- und/oder Entformungsmittel, Thermostabilisatoren, Blendpartner wie ABS, Polyester, z. B. PET und/oder PBT, oder SAN, Verträglichkeitsvermittler, UV-Absorber und/oder IR-Absorber.

Bevorzugte Entformungsmittel sind Ester aliphatischer langkettiger Carbonsäuren mit ein- oder mehrwertigen aliphatischen und/oder aromatischen Hydroxyverbindungen. Besonders bevorzugt sind Pentaerythrittetrastearat, Glycerinmonostearat, Stearylstearat und Propandioldistearat, bzw. Gemische daraus.

Bevorzugte UV-Stabilisatoren weisen eine möglichst geringe Transmission unterhalb 400 nm und eine möglichst hohe Transmission oberhalb von 400 nm auf. Für den Einsatz in der erfindungsgemäßen Zusammensetzung besonders geeignete Ultraviolett-Absorber sind Benzotriazole, Triazine, Benzophenone und/oder arylierte Cyanoacrylate.

Besonders geeignete Ultraviolett-Absorber sind Hydroxy-Benzotriazole, wie 2-(3',5'-Bis-(1,1-dimethylbenzyl)-2'-hydroxy-phenyl)-benzotriazol (Tinuvin® 234, Ciba Spezialitätenchemie, Basel), 2-(2'-Hydroxy-5'-(tert.-octyl)-phenyl)-benzotriazol (Tinuvin® 329, Ciba Spezialitätenchemie, Basel), 2-(2'-Hydroxy-3'-(2-butyl)-5'-(tert.butyl)-phenyl)-benzotriazol (Tinuvin® 350, Ciba Spezialitätenchemie, Basel), Bis-(3-(2H-benztriazolyl)-2-hydroxy-5-tert.-octyl)methan, (Tinuvin® 360, Ciba Spezialitätenchemie, Basel), (2-(4,6-Diphenyl-1,3,5-triazin-2-yl)-5-(hexyloxy)-phenol (Tinuvin® 1577, Ciba Spezialitätenchemie, Basel), sowie der Benzophenone 2,4-Dihydroxy-benzophenon (Chimasorb® 22, Ciba Spezialitätenchemie, Basel) und 2-Hydroxy-4-(octyloxy)-benzophenon (Chimassorb® 81, Ciba, Basel), 2-Cyano-3,3-diphenyl-2-propensäure-2-ethylhexylester, 2,2-Bis[[(2-cyano-1-oxo-3,3-diphenyl-2-propenyl)oxy]-methyl]-1,3-propandiylester (9CI) (Uvinul® 3030, BASF AG Ludwigshafen), 2-[2-Hydroxy-4-(2-ethylhexyl)oxy]phenyl-4,6-di(4-phenyl)phenyl-1,3,5-triazin (CGX UVA 006, Ciba Spezialitätenchemie, Basel) oder Tetraethyl-2,2'-(1,4-phenylen-dimethyliden)-bismalonat (Hostavin® B-Cap, Clariant AG).

Besonders bevorzugte spezielle UV-Stabilisatoren sind beispielsweise Tinuvin® 360, Tinuvin® 350, Tinuvin® 329, Hostavin® B-CAP, besonders bevorzugt TIN 329 und Hostavin® B-Cap. Es können auch Mischungen dieser Ultraviolett-Absorber eingesetzt werden.

Sofern UV-Absorber enthalten sind, enthält die Zusammensetzung bevorzugt Ultraviolett-Absorber in einer Menge von 0 ppm bis 6000 ppm, weiter bevorzugt 500 ppm bis 5000 ppm, noch weiter bevorzugt 1000 ppm bis 2000 ppm, bezogen auf die Gesamtzusammensetzung.

Geeignete IR-Absorber sind beispielsweise in EP 1 559 743 A1, EP 1 865 027 A1, DE 10022037 A1, DE 10006208 A1 sowie in den italienischen Patentanmeldungen RM2010A000225, RM2010A000227 sowie RM2010A000228 offenbart. Von den in der zitierten Literatur genannten IR-Absorbern sind solche auf Borid- und Wolframatbasis, insbesondere Cäsiumwolframat oder Zink-dotiertes Cäsiumwolframat, sowie auf ITO und ATO basierende Absorber sowie Kombinationen daraus bevorzugt.

Geeignete Farbmittel können Pigmente, organische und anorganische Pigmente, Ruß und/oder Farbstoffe sein. Farbmittel oder Pigmente im Sinne der vorliegenden Erfindung sind Schwefelhaltige Pigmente wie Cadmiumrot oder Cadmiumgelb, Eisencyanid-basierte Pigmente wie Berliner Blau, Oxid-Pigmente wie Titandioxid, Zinkoxid, rotes Eisenoxid, schwarzes Eisenoxid, Chromoxid, Titangelb, Zink-Eisen-basiertes Braun, Titan-Cobalt-basiertes Grün, Cobaltblau, Kupfer-Chrom-basiertes Schwarz und Kupfer-Eisen-basiertes Schwarz oder Chrom-basierte Pigmente wie Chromgelb, Phthalocyanin-abgeleitete Farbstoffe wie Kupfer-Phthalocyanin-Blau oder Kupfer-Phthalocyanin-Grün, kondensierte polycyclische Farbstoffe und Pigmente wie Azo-basierende (z. B. Nickel-Azogelb), Schwefel-Indigo-Farbstoffe, Perinon-basierte, Perylen-basierte, Chinacridonabgeleitete, Dioxazin-basierte, Isoindolinon-basierte und Chinophthalon-abgeleitete Derivate, Anthrachinon-basierte, heterocyclische Systeme.

Konkrete Beispiele für Handelsprodukte sind z. B. MACROLEX® Blau RR, MACROLEX® Violett 3R, MACROLEX® Violett B (Lanxess AG, Deutschland), Sumiplast® Violett RR, Sumiplast® Violett B, Sumiplast® Blau OR, (Sumitomo Chemical Co., Ltd.), Diaresin® Violett D, Diaresin® Blau G, Diaresin® Blau N (Mitsubishi Chemical Corporation), Heliogen® Blau oder Heliogen® Grün (BASF AG, Deutschland). Von diesen sind Cyaninderivate, Chinolinderivate, Anthrachinonderivate, Phthalocyaninderivate bevorzugt.

Füllstoffe verschieden von Komponente B) können ebenfalls zugesetzt werden, sofern sie nach Art und Menge das Eigenschaftsniveau der vorliegenden Erfindung nicht beeinträchtigen. In Frage kommen hierfür prinzipiell alle feinvermahlenen organischen und anorganischen Materialien. Diese können z.B. partikel-, schuppenförmigen oder faserförmigen Charakter haben. Beispielhaft seien an dieser Stelle Kreide, Quarzpulver, Titandioxid, Silikate/Aluminosilikate wie z.B. Wollastonit, Glimmer/Tonschichtmineralien, Montmorillonit, insbesondere auch in einer durch Ionenaustausch modifizierten, organophilen Form, Kaolin, Zeolithe, Vermiculit sowie Aluminiumoxid, Silica, Glasfasern, Carbonfasern, Magnesiumhydroxid und Aluminiumhydroxid genannt. Es können auch Mischungen verschiedener anorganischer Materialien zum Einsatz kommen. Als anorganische Füllstoffe kommen insbesondere Titandioxid, im allgemeinen in einer Menge von 0 bis 2,5 Gew.-%, bezogen auf die Summe der Gesamtzusammensetzung, oder Bariumsulfat in Betracht.

Darüber hinaus können weitere Bestandteile zugesetzt werden, die nach Art des Bestandteils und Menge das Eigenschaftsniveau der vorliegenden Erfindung nicht beeinträchtigen.

Erfindungsgemäß bevorzugte Zusammensetzungen enthalten
A) mindestens 60 Gew.-% aromatisches Polycarbonat,
B) 5 bis 35 Gew.-% Talk,
C) 0,1 bis 8 Gew.-% PMMI-Copolymer und
D) optional weitere Additive.

Weiter bevorzugte erfindungsgemäße Zusammensetzungen enthalten
A) mindestens 68 Gew.-% aromatisches Polycarbonat,
B) 10 bis 30 Gew.-% Talk,
C) 0,2 bis 6 Gew.-% PMMI-Copolymer und
D) optional weitere Additive.

Noch weiter bevorzugte erfindungsgemäße Zusammensetzungen bestehen aus
A) mindestens 68 Gew.-% aromatischem Polycarbonat,
B) 10 bis 30 Gew.-% Talk,
C) 0,2 bis 6 Gew.-% PMMI-Copolymer und
D) optional ein oder mehreren weiteren Additiven, ausgewählt aus der Gruppe, bestehend aus Flammschutzmitteln, Antitropfmitteln, Schlagzähmodifikatoren, von Komponente B verschiedenen Füllstoffen, Antistatika, Farbmitteln, Pigmenten, Ruß, Gleit- und/oder Entformungsmitteln, Thermostabilisatoren, Verträglichkeitsvermittlern, UV-Absorbern und/oder IR-Absorbern.

Ganz besonders bevorzugte erfindungsgemäße Zusammensetzungen bestehen aus
A) mindestens 68 Gew.-% aromatischem Polycarbonat,
B) 15 bis 25 Gew.-% Talk,
C) 1,5 Gew.-% bis 6 Gew.-%, insbesondere 4 bis 6 Gew.-%, PMMI-Copolymer und
D) optional bis zu 10,0 Gew.-% einem oder mehreren weiteren Additiven, ausgewählt aus der Gruppe, bestehend aus Flammschutzmitteln, Antitropfmitteln, Schlagzähmodifikatoren, von Komponente B verschiedenen Füllstoffen, Antistatika, Farbmitteln, Pigmenten, Ruß, Gleit- und/oder Entformungsmitteln, Thermostabilisatoren, Verträglichkeitsvermittlern, UV-Absorbern und/oder IR-Absorbern.

Dabei beträgt insbesondere der Anteil an Methylmethacrylimid-Einheiten mindestens 30 Gew.-%, der Anteil an Methylmathacrylat-Einheiten 3 bis 65 Gew.-% und der Anteil an Methylmethacrylsäure- und Methylmethacrylanhydrid-Einheiten in Summe bis zu 15 Gew.-%, jeweils bezogen auf das Gesamtgewicht des in der Zusammensetzung enthaltenen PMMI-Copolymers, und die Säurezahl, bestimmt nach DIN 53240-1:2013-06, 15 bis 50 mg, ganz besonders bevorzugt 20 bis 45 mg KOH/g.

Die Herstellung der erfindungsgemäßen Polymer-Zusammensetzungen, enthaltend die vermischten Komponenten A), B), C) und ggf. D) sowie ggf. weitere Bestandteile, kann unter Verwendung von Pulvervormischungen erfolgen. Es können auch Vormischungen aus Granulaten oder Granulaten und Pulvern mit den erfindungsgemäßen Zusätzen verwendet werden. Es können auch Vormischungen verwendet werden, die aus Lösungen der Mischungskomponenten in geeigneten Lösungsmitteln, wobei gegebenenfalls in Lösung homogenisiert wird und das Lösungsmittel anschließend entfernt wird, hergestellt worden sind. Insbesondere können die als Komponente D bezeichneten Additive und auch weitere Bestandteile der erfindungsgemäßen Zusammensetzungen durch bekannte Verfahren oder als Masterbatch eingebracht werden. Die Verwendung von Masterbatchen ist insbesondere zum Einbringen von Additiven und weiteren Bestandteilen bevorzugt, wobei insbesondere Masterbatche auf Basis der jeweiligen Polymermatrix verwendet werden.

Die erfindungsgemäßen Zusammensetzungen können beispielsweise extrudiert werden. Nach der Extrusion kann das Extrudat abgekühlt und zerkleinert werden. Die Zusammenführung und Durchmischung einer Vormischung in der Schmelze kann auch in der Plastifiziereinheit einer Spritzgussmaschine erfolgen. Hierbei wird die Schmelze im anschließenden Schritt direkt in einen Formkörper überführt.

Es hat sich insbesondere herausgestellt, dass die erfindungsgemäßen Zusammensetzungen besonders geeignet sind für die Herstellung von Extrudaten, bevorzugt für die Extrusion von Profilen und Platten.

Aufgrund der erhöhten Wärmeleitfähigkeit ist der Einsatz der Talk-gefüllten Polycarbonatzusammensetzungen z.B. als Kühlkörper (Wärmesenke, engl. Heatsinks) in Lampenfassungen oder für sonstige elektronische Bauelemente bevorzugt.

Zudem ist auch der Einsatz der Zusammensetzungen als Gehäusematerial im E/E-Bereich, etwa für Stromzähler, mobile Elektronikgeräte (Handy, Laptop , Tablet, etc.) möglich, ebenso für TV-Gehäuse, sowie als Material, insbesondere als Gehäusematerial, für Geräte für den Haushalt (Staubsauger, Klimageräte, Rasierer, etc.).

Die erfindungsgemäßen Zusammensetzungen sind auch für Anwendungen geeignet, die eine hohe Oberflächenqualität erfordern, z.B. in optischen Anwendungen wie etwa für Reflektoren.

In Polycarbonatzusammensetzungen, die bestimmte Flammschutzeigenschaften aufweisen müssen, wird Talk mitunter als Additiv eingesetzt um das Brandverhalten zu verbessern. Auch hier muss ein geeigneter Talk-Stabilisator verwendet werden.

Die erfindungsgemäßen Zusammensetzungen sind auch als Matrix Material für die Composit-Herstellung geeignet.

Eine Stabilisierung mittels PMMI-Copolymer von Polycarbonat-Zusammensetzungen ist insbesondere da bevorzugt, wo hohe Verweilzeiten, d.h. Verweilzeiten von mehreren Minuten, vorliegen, d.h. beispielsweise bei Ko-Knetern.

### Beispiele:

### Polymere:

PC: Ein kommerziell erhältliches Polycarbonat auf Basis von Bisphenol A mit einer MVR von 19 cm³/10 min (300°C/1,2 kg, ISO 1133-1:2011) und einer Erweichungstemperatur (VST/B 120; ISO 306:2013) von 145°C (Makrolon® 2408 der Covestro Deutschland AG). M_{w}, bestimmt wie nachfolgend beschrieben, ca. 23.900 g/mol.

### Stabilisatoren:

**PMMI1:** Polymethacrylmethylimid-Copolymer der Firma Evonik (Pleximid® 8803) mit einer Erweichungstemperatur (VST/B 50; ISO 306:2013) von 130°C. Säurezahl: 22,5 mg KOH/g, bestimmt nach DIN 53240-1 (Juni 2013). Anteil MMI (Methylmethacrylimid): 36,8 Gew.-%, Anteil MMA (Methylmathacrylat): 51,7 Gew.-%, Anteil MMS (Methylmethacrylsäure) + MMAH (Methylmethacrylanhydrid): 11,5 Gew.-%, jeweils bezogen auf das Gesamtgewicht des PMMI und ermittelt mittels quantitativer ¹H-NMR-Spektroskopie.

**PMMI2:** Polymethacrylmethylimid-Copolymer der Firma Evonik (Pleximid® TT50) mit einer Erweichungstemperatur (VST/B 50; ISO 306:2013) von 150°C. Säurezahl: 22,5 mg KOH/g, bestimmt nach DIN 53240-1 (Juni 2013). Anteil MMI: 83,1 Gew.-%, Anteil MMA: 13,6 Gew.-%, Anteil MMS + MMAH: 3,3 Gew.-%, jeweils bezogen auf das Gesamtgewicht des PMMI und ermittelt mittels quantitativer ¹H-NMR-Spektroskopie.

**PMMI3:** Polymethacrylmethylimid-Copolymer der Firma Evonik (Pleximid® TT70) mit einer Erweichungstemperatur (VST/B 50; ISO 306:2013) von 170°C. Säurezahl: 41,5 mg KOH/g, bestimmt nach DIN 53240-1 (Juni 2013). Anteil MMI: 94,8 Gew.-%, Anteil MMA: 4,6 Gew.-%, Anteil MMS + MMAH: 0,6 Gew.-%, jeweils bezogen auf das Gesamtgewicht des PMMI und ermittelt mittels quantitativer ¹H-NMR-Spektroskopie.

**Stab1:** Ein säuremodifiziertes Ethylen-Wachs der Firma Mitsui Chemical America, Inc. (Hiwax™ 1105A) mit einem mittleren Molekulargewicht (Gelpermeationschromatographie in ortho-Dichlorbenzol bei 150 °C mit Polystyrolkalibrierung) M_{w} = 6301 g/mol, Mₙ = 1159 g/mol und mit einer Säurezahl von 52,6 mg KOH/g (Testmethode JIS K0070). Maleinsäureanhydridanteil: 4,4 Gew.-%, bezogen auf das Gesamtgewicht des Terpolymers.

**Stab2:** Ein Maleinsäureanhydrid-modifiziertes Polypropylen-Copolymer der Firma Honeywell (AC907P) mit einem mittleren Molekulargewicht (Gelpermeationschromatographie in ortho-Dichlorbenzol bei 150 °C mit Polystyrolkalibrierung) M_{w} = 20.700 g/mol, Mₙ = 1460 g/mol und mit einer Säurezahl von 78 mg KOH/g (ASTM D-1386)).

### Füllstoffe:

**Talk:** Ein kompaktierter Talk der Firma IMI Fabi mit einem Talkgehalt von 99 Gew.-%, einem Eisenoxidgehalt von 0,4 Gew.-%, einem Aluminiumoxidgehalt von 0,4 Gew.-%, Glühverlust von 6,0 Gew.-%, D₅₀ (Sedimentationsanalyse, Sedigraph5120) von 0,65 µm; BET-Oberfläche 13,5 m²/g, Dichte (bestimmt nach DIN53193) von 2.8 g/cm³ (HTPultra5C).

### Herstellungsparameter:

Als Extruder wurde ein DSM Micro-Extruder MIDI 2000 mit einer Kapazität von 15 cm³ verwendet. Die Massetemperatur im Extruder betrug 280 °C, die Drehzahl 150 U/min und die Verweilzeit (VWZ) war 5 Minuten bzw. 10 Minuten. Für den Spritzguss wurde eine DSM Injection Molding Machine verwendet. Die Massetemperatur beim Spritzguss betrug: 300°C, die Werkzeugtemperatur 80°C.

### Bestimmungsmethoden:

**M_{w}**: Gelpermeationschromatographie, kalibriert gegen Bisphenol A-Polycarbonat-Standards, unter Verwendung von Dichlormethan als Elutionsmittel. Kalibrierung mit linearen Polycarbonaten (aus Bisphenol A und Phosgen) bekannter Molmassenverteilung der PSS Polymer Standards Service GmbH, Deutschland, Kalibrierung nach der Methode 2301-0257502-09D (aus dem Jahre 2009 in deutscher Sprache) der Currenta GmbH & Co. OHG, Leverkusen. Das Elutionsmittel ist Dichlormethan. Säulenkombination aus vernetzten Styrol-Divinylbenzolharzen. Durchmesser der analytischen Säulen: 7,5 mm; Länge: 300 mm. Partikelgrößen des Säulenmaterials: 3 µm bis 20 µm. Konzentration der Lösungen: 0,2 Gew.-%. Flussrate: 1,0 ml/min, Temperatur der Lösungen: 30°C. Injektvolumen; 100 µl. Detektion mittels UV-Detektor.

Der **Yellowness Index** (Y.I.) wurde gemessen nach ASTM E313-10. Die Transmissionswerte (Ty) wurden bestimmt nach ASTM-E-308. Sowohl Y.I. als auch Ty wurden nach D65,10° (Lichtart: D65/Beobachter: 10°) ausgewertet. Die vermessenen Proben hatten eine Geometrie von 6,0 mm x 3,5 mm x 1,5 mm.

Die **Viskosität** der Polymerschmelzen wurde gemessen nach ISO 11443:2005bei einer Schmelzetemperatur von 300°C.

Die **Vicat-Erweichungstemperatur** (VST/B/50) der Zusammensetzungen wurde gemessen an Prüfkörpern nach ISO 306:2013.

Das **Zugmodul** und die **Zugfestigkeit** der Zusammensetzungen wurden gemessen an Prüfkörpern nach ISO 527-1:2012.

Die **Durchstoßkraft** und **-verformung** der Zusammensetzungen wurden gemessen an Prüfkörpern nach ISO 6603-2:2000.

### Ergebnisse:

### Beispiele:

**Tabelle 1: Talk-freies Polycarbonat und der Einfluss von PMMI**

| | | **1V** | **2V** | **3V** | **4V** | **5V** | **6V** | **7V** |
|---|---|---|---|---|---|---|---|---|
| | | **Gew.-%** | **Gew.-%** | **Gew.-%** | **Gew.-%** | **Gew.-%** | **Gew.-%** | **Gew.-%** |
| **PC** | | 100 | 99,8 | 99,5 | 99 | 98 | 96 | 94 |
| **PMMI1** | | | 0,2 | 0,5 | 1 | 2 | 4 | 6 |
| | **VWZ [min]** | | | | | | | |
| **M_{w} [g/mol]** | 5 | 23365 | 23408 | 23395 | 23409 | 23493 | 23554 | 23689 |
| **Y.I.** (D65, **10°)** | 5 | 3,69 | 3,21 | 6,35 | 12,75 | 18,70 | 26,53 | 29,27 |
| | 10 | 4,01 | 3,49 | 7,57 | 14,41 | 19,25 | 30,29 | 32,57 |
| **Δ Y.I.** | | 0,32 | 0,27 | 1,21 | 1,66 | 0,56 | 3,76 | 3,30 |

In ungefülltem Polycarbonat kommt es zu keinem wesentlichen Abbau der Polymerketten. Ein Stabilisator ist daher nicht erforderlich. Wie sich aus Tabelle 1 erkennen lässt, hat der Zusatz von PMMI zu Füllstoff-freiem Polycarbonat keinen negativen Einfluss auf die Molmasse. Die mittleren Molmassen sind auf einem im Rahmen der Messgenauigkeit konstanten Niveau. Wie in Tabelle 1 zu erkennen, nehmen die optischen Eigenschaften (Y.I.) und die Farbstabilität (ΔY.I. (5min/10 min)) mit steigendem PMMI-Copolymer-Gehalt ab. Vergleicht man diese Werte allerdings mit den Zusammensetzungen in Tabelle 4, die Stab 1 und Stab 2 enthalten (Beispiele 20V und 21V), so ist die Vergilbung mit PMMI weniger stark ausgeprägt. Zudem führen sowohl Stab1 als auch Stab2 zu einer starken Reduktion der Transmission in ungefülltem Polycarbonat.

**Tabelle 2: Talk-haltige Polycarbonat-Zusammensetzungen und der Einfluss von PMMI**

| | | **8V** | **9** | **10** | **11** | **12** | **13** | **14** |
|---|---|---|---|---|---|---|---|---|
| | | **Gew.-%** | **Gew.-%** | **Gew.-%** | **Gew.-%** | **Gew.-%** | **Gew.-%** | **Gew.-%** |
| **PC** | | 80 | 79,8 | 79,5 | 79 | 78 | 76 | 74 |
| **Talk** | | 20 | 20 | 20 | 20 | 20 | 20 | 20 |
| **PMMI1** | | | 0,2 | 0,5 | 1 | 2 | 4 | 6 |
| | **VWZ [min]** | | | | | | | |
| **M_{w} [g/mol]** | 5 | 15410 | 18328 | 19429 | 18596 | 20175 | 21731 | 21980 |
| Y.I. **(D65, 10°)** | 5 | 20,72 | 22,98 | 32,62 | 41,70 | 49,14 | 4,60 | 6,46 |
| | 10 | 36,71 | 35,91 | 38,87 | 46,32 | 39,50 | 11,58 | 10,13 |
| **Δ Y.I.** | | 15,99 | 12,93 | 6,25 | 4,62 | -9,64 | 6,98 | 3,67 |

Betrachtet man Talk-haltigen Polycarbonat-Zusammensetzungen, so sind deutliche Unterschiede im Vergleich zu Talk-freien Polycarbonat-Zusammensetzungen zu erkennen. Der Zusatz von Talk führt bereits bei 5 Minuten Verweilzeit zu einem erheblichen Molekulargewichtsabbau (M_{w}) des Polymers von etwa 23.900 g/mol auf ca. 15.000 g/mol. Mit zunehmendem Gehalt an PMMI lässt sich der Polymerabbau allerdings deutlich verringern. Bei 2 Gew.-% zugesetztem PMMI (bezogen auf die Gesamtzusammensetzung) ist der Effekt bereits attraktiv. Bei etwa 4-6 Gew.-% zugesetztem PMMI ist ein Optimum erreicht (siehe hierzu auch die Beispiele 30-33 in Tabelle 5). Ein Molekulargewichtsabbau lässt sich durch die Zugabe von PMMI in wirtschaftlich attraktiven Mengen nicht vollständig vermeiden, aber auf ein Niveau bringen, das einen so geringen Molekulargewichtsabbau bedeutet, dass dieser vernachlässigbar ist. Es ist zudem zu berücksichtigen, dass eine Verweilzeit von 5 Minuten bei erhöhter Temperatur unter realen Prozessbedingungen eher den Extremfall darstellt. Das heißt, dass mit den hier vorliegenden Ergebnissen auch gezeigt werden kann, dass insbesondere auch für Extruder mit hohen Verweilzeiten, etwa Ko-Knetern, eine gute Stabilisierung realisierbar ist. Dabei führt der Zusatz von PMMI zu Talk-gefülltem Polycarbonat erst einmal grundsätzlich zu einer Erhöhung des Y.I.-Wertes und zu einer Verschlechterung der optischen Eigenschaften. Überraschend ist jedoch, dass, anders als bei ungefüllten Systemen, sich hier jedoch im Plateaubereich, beginnend ab ca. 3 Gew.-%, bevorzugt ab etwa 4 Gew.-% (siehe Beispiele 13 und 14 in Tabelle 2) ein erheblicher Abfall der Y.I. Werte feststellen lässt, der bei der geringeren Verweilzeit von 5 min zu akzeptablen Y.I.-Werten führt, die mit denen von ungefülltem Polycarbonat vergleichbar sind.

**Tabelle 3: Talk-haltige Polycarbonat-Zusammensetzungen und der Einfluss unterschiedlicher PMMI-Typen**

| | | **15V** | **16** | **17** | **18** |
|---|---|---|---|---|---|
| | | **Gew.-%** | **Gew.-%** | **Gew.-%** | **Gew.-%** |
| **PC** | | 80 | 79 | 79 | 79 |
| **Talk** | | 20 | 20 | 20 | 20 |
| **PMMI1** | | | 1 | | |
| **PMMI2** | | | | 1 | |
| **PMMI3** | | | | | 1 |
| | **VWZ [min]** | | | | |
| **M_{w} [g/mol]** | 5 | 15410 | 18596 | 19730 | 19906 |
| **Y.I.** (D65, **10°)** | 5 | 20,72 | 41,70 | 32,35 | 26,51 |
| | 10 | 36,71 | 46,32 | 39,31 | 39,53 |
| **Δ Y.I.** | | 16,00 | 4,62 | 6,96 | 13,02 |

Die verwendeten PMMI-Typen unterscheiden sich in ihrem Gehalt an MMI, MMA, Säure und Anhydrid.

Überraschenderweise wurde für Talk-gefülltes Polycarbonat gefunden, dass, nicht wie erwartet, das PMMI mit dem niedrigsten Gehalt an MMI (PMMI1) zur besten Verträglichkeit -geringster Molmassenabbau, auch am wenigsten Vergilbung- führt, sondern das PMMI mit dem höchsten MMI-Gehalt und gleichzeitig niedrigsten Säure-Anteil (PMMI3). Die Messungen der Y.I.-Werte nach 5 Minuten Verweilzeit zeigen, dass mit steigendem MMI-Gehalt (PMMI1 < PMMI2 < PMMI 3) auch die Vergilbung reduziert wird. Ein Vergleich der ΔY.I.-Werte zwischen 5 und 10 Minuten Verweilzeit zeigt jedoch, dass bei kürzerer und bei längerer Verweilzeit, verglichen miteinander, der Grad der Vergilbung mit steigendem MMI-Gehalt stärker zunimmt. Auch wenn das Y.I.-Anfangsniveau von mit Talk gefülltem Polycarbonat ohne PMMI am niedrigsten ist, so ist der Unterschied zwischen 5 Minuten und 10 Minuten Verweilzeit dort am größten (ΔY.I. = 16). Daraus lässt sich schließen, dass die Farbstabilität von PMMI-Copolymer + Talk + PC-Systemen vom Gehalt an MMI und der Dauer der thermischen Belastung des Materials abhängt.

**Tabelle 4: Vergleich von unterschiedlichen Säure/Maleinsäureanhydrid-funktionalisierten Copolymeren als Stabilisatoren**

| | | **19V** | **20V** | **21V** | **22** | **23** | **24** |
|---|---|---|---|---|---|---|---|
| | | **Gew.-%** | **Gew.-%** | **Gew.-%** | **Gew.-%** | **Gew.-%** | **Gew.-%** |
| **PC** | | 99 | 99 | 99 | 79 | 79 | 79 |
| **Talk** | | | | | 20 | 20 | 20 |
| **PMMI1** | | 1 | | | 1 | | |
| **Stab1** | | | 1 | | | 1 | |
| **Stab 2** | | | | 1 | | | 1 |
| | VWZ [min] | | | | | | |
| **M_{w} [g/mol]** | 5 | 23409 | 23382 | 23104 | 18596 | 20816 | 22157 |
| Y.I. **(D65, 10°)** | 5 | 12,75 | 22,98 | 16,55 | 41,70 | 35,51 | 27,17 |
| | 10 | 14,41 | 29,53 | 25,70 | 46,32 | 54,72 | 46,49 |
| **Δ Y.I.** | | 1,66 | 6,55 | 9,15 | 4,62 | 19,21 | 19,32 |
| **Ty (%)** | | 80,87 | 48,25 | 61,77 | - | - | - |

In Kombination mit Talk und jeweils 1 Gew.-% Additiv zeigt Stab2 zwar die beste Stabilisierung, insbesondere bei längerer Verweilzeit aber zeigt sich hier der negative Einfluss auf die optischen Eigenschaften. Die Zusammensetzungen, die mit Stab1 und Stab2 versetzt sind, neigen zu deutlich stärkerer Vergilbung (größeres Δ Y.I.). Außerdem weisen die Zusammensetzungen mit den polyolefinischen Copolymeren bereits bei 1 Gew-% in ungefülltem PC eine deutlich verringerte Transmission auf, welches sich negativ auf die Einfärbbarkeit auswirkt.

**Tabelle 5: Vergleich von unterschiedlichen Füllstoff/Additiv-Verhältnissen**

| | | **25** | **26** | **27** | **28** | **29** | **30** | **31** |
|---|---|---|---|---|---|---|---|---|
| | | **Gew.-%** | **Gew.-%** | **Gew.-%** | **Gew.-%** | **Gew.-%** | **Gew.-%** | **Gew.-%** |
| **PC** | | 89 | 87,5 | 85 | 79,5 | 78 | 76 | 75 |
| **Talk** | | 10 | 10 | 10 | 20 | 20 | 20 | 20 |
| **PMMI1** | | 1 | 2,5 | 5 | 0,5 | 2 | 4 | 5 |
| | | | | | | | | |
| **PMMI1/Talk** | | 0,1 | 0,25 | 0,5 | 0,025 | 0,1 | 0,2 | 0,25 |
| | VWZ [min] | | | | | | | |
| **M_{w} [g/mol]** | 5 | 22465 | 22678 | 22915 | 19429 | 20175 | 21731 | 22270 |

**Tabelle 5: Fortsetzung**

| | | **32** | **33** | **34** | **35** | **36** |
|---|---|---|---|---|---|---|
| | | **Gew.-%** | **Gew.-%** | **Gew.-%** | **Gew.-%** | **Gew.-%** |
| **PC** | | 74 | 72 | 67 | 65 | 62,5 |
| **Talk** | | 20 | 20 | 30 | 30 | 30 |
| **PMMI1** | | 6 | 8 | 3 | 5 | 7,5 |
| | | | | | | |
| **PMMI1/Talk** | | 0,3 | 0,4 | 0,1 | 0,16 | 0,25 |
| | VWZ [min] | | | | | |
| **M_{w} [g/mol]** | 5 | 21980 | 22400 | 21136 | 20924 | 21038 |

Bei Füllstoffgehalten von 10 bzw. 20 Gew-% nimmt die Stabilisierungswirkung des PMMI1 mit steigendem PMMI-Copolymer-Gehalt zu. Diese Zunahme ist bei 20 Gew-% besonders ausgeprägt. Bei 30 Gew-% Talk allerdings scheint die Stabilisierung im untersuchten Bereich von 3 bis 7,5 Gew.-% PMMI-Copolymer unabhängig vom PMMI-Copolymer-Gehalt auf einem konstant guten Niveau zu bleiben. Erfindungsgemäß bevorzugte Verhältnisse liegen daher insbesondere vor, wenn der Anteil an Talk 15 bis 25 Gew.-% und das Verhältnis PMMI-Copolymer zu Talk 0,1 bis 0,6, insbesondere 0,2 bis 0,5 beträgt.

**Tabelle 6: Messung von Materialeigenschaften an stabilisierten Compounds^{[1]}**

| | **37** | **38** | **39** | **40** | **41** | **42** |
|---|---|---|---|---|---|---|
| | **Gew.-%** | **Gew.-%** | **Gew.-%** | **Gew.-%** | **Gew.-%** | **Gew.-%** |
| **PC** | 80 | 79 | 78 | 76 | 74 | 72 |
| **Talk** | 20 | 20 | 20 | 20 | 20 | 20 |
| **PMMI1** | | 1 | 2 | 4 | 6 | 8 |
| **Stab1** | | | | | | |
| | | | | | | |
| **Viskosität** [Pa·s]^{[2]} | 58 | 176 | 213 | 216 | 209 | 209 |
| **Vicat-Temperatur** [°C] (Methode B, 50 K/h) | 140,1 | 141,6 | 143,3 | 143,5 | 144,2 | 145 |
| **Zugmodul** [MPa] | 4520 | 4904 | 4932 | 4880 | 4946 | 5085 |
| **Zugfestigkeit** [MPa] | 59,4 | 70,1 | 70,3 | 70,8 | 71,2 | 72,1 |
| **Durchstoß, Maximalkraft** [N] | 385 | 3140 | 4225 | 4179 | 4098 | 3206 |
| **Durchstoß, Verformung** [mm] | 4,3 | 8,7 | 11,7 | 11,2 | 10,8 | 9,1 |
| **M_{w} [g/mol]^{[3]}** | 17604 | 22614 | 23053 | 23420 | 23638 | 23816 |

**Tabelle 6: Fortsetzung**

| | **43** | **44** | **45** |
|---|---|---|---|
| | **Gew.-%** | **Gew.-%** | **Gew.-%** |
| **PC** | 79 | 78 | 76 |
| **Talk** | 20 | 20 | 20 |
| **PMMI1** | | | |
| **Stab1** | 1 | 2 | 4 |
| | | | |
| **Viskosität** [Pa·s]^{[2]} | 159 | 156 | 102 |
| **Vicat-Temperatur** [°C] (Methode B, 50 K/h) | 142,5 | 144,1 | 142,4 |
| **Zugmodul** [MPa] | 4510 | 4248 | 4175 |
| **Zugfestigkeit** [MPa] | 57,4 | 53,7 | 51,2 |
| Durchstoß, | 4144 | 3885 | 1495 |
| **Maximalkraft** [N] | | | |
| **Durchstoß, Verformung** [mm] | 14,1 | 13,9 | 10,6 |
| **M_{w} [g/mol]^{[3]}** | 23229 | 23876 | 24038 |

| | | | |
|---|---|---|---|
| [1] Die Zusammensetzungen wurden auf einem Zweiwellenextruder (ZE 25 AX 40D-UTX, Drehzahl 100 upm, Durchsatz 10 kg/h, Massetemperatur 300°C) der Firma Berstorff hergestellt. Der Talk wurde dabei mittels Seitenextruder (etwa auf halber Länge der Verfahrenseinheit) zugegeben. [2] Die Schmelzeviskosität wurde bei 300°C und einer Scherrate von 1000 s⁻¹ in Anlehnung an ISO 11443:2005 gemessen. [3] Die Verweilzeit der Polycarbonat-Talk-Mischung auf dem Extruder lag bei circa 25 Sekunden (gemessen ab Zugabe des Talks via Seitenextruder). | | | |

Mit zunehmendem Gehalt an PMMI1 nimmt das Zugmodul des Materials zu. Gleichermaßen steigt die Zugfestigkeit, und somit die Interaktion zwischen Füllstoffes und Polymer-Matrix, an. Die Wärmeformbeständigkeit, hier gemessen anhand der Vicat-Erweichungstemperatur, kann mit steigendem Gehalt an PMMI1 ebenfalls erhöht werden. Dies liegt zum einen an der effizienteren Stabilisierung des Füllstoffes und einem somit reduziertem Abbau der Polymermatrix. Zum anderen erhöht sich die Viskosität der Zusammensetzung durch die höhere Viskosität des Additives selbst. Im Vergleich dazu nehmen sowohl das Zugmodul als auch die Zugfestigkeit mit zunehmendem Gehalt an Stab1 ab. Oberhalb von 2 Gew-% macht sich der weichmachende Effekt des polyolefinischen Copolymers insbesondere in der Mechanik der Compounds bemerkbar. Dies spiegelt sich auch in der Abnahme der Viskosität mit steigendem Wachs-Gehalt (Stab1) wider. Der steigende Wachs-Gehalt macht sich im Spritzguss durch verstärkte Delamination bemerkbar (Beispiele 43-45), die bei Verwendung von PMMI1 nicht so stark ausgeprägt ist (Beispiele 38-42). Wie in Tabelle 6 dargestellt, lässt sich der Trend der Stabilisierung durch PMMI-Zugabe auch auf einem Standardextruder nachstellen. Die Absolutwerte liegen, bedingt durch die wesentlich kürzere Verweilzeit von ca. 25 Sekunden, oberhalb der Messwerte aus den vorherigen Versuchsreihen. Das Optimum liegt auch hier oberhalb von 1 Gew.-% PMMI1.

Vergleicht man die Ergebnisse des Durchstoßversuches, so ist bei 2 Gew.-% bis 6 Gew.-% PMMI1, bezogen auf die fertige Zusammensetzung, ein Optimum hinsichtlich des Energieeintrags sowie der maximalen Verformung erreicht. Zugmodul und Vicat-Temperatur sind hoch, der Molekulargewichtsabbau ist niedrig und die Mischungen sind homogen ohne eine Delamination an der Oberfläche.

Vergleicht man die Ergebnisse aus Tabelle 5 und 6, so ist das Polycarbonat mit 20 Gew-% Talk dann ausreichend stabilisiert (gemessen am Molekulargewicht) wenn 5-8 Gew-% PMMI1 zugegeben werden. In diesem Bereich weist das Material zudem eine deutlich gesteigerte Wärmeformbeständigkeit sowie verbesserte mechanische Eigenschaften auf.

## Patentansprüche

1. Verwendung mindestens eines Polymethacrylmethylimid-Copolymers (PMMI-Copolymers) zur Reduzierung des Molekulargewichtsabbaus von aromatischem Polycarbonat bei Talk-haltigen Polycarbonat-Zusammensetzungen beim Compoundieren.

2. Verwendung gemäß Anspruch 1, wobei das PMMI-Copolymer 3 bis 65 Gew.-% Methylmathacrylat-Einheiten, mindestens 30 Gew.-% Methylmethacrylimid-Einheiten, in Summe bis zu 15 Gew.-% Methylmethacrylsäure-Einheiten und Methylmethacrylanhydrid-Einheiten, jeweils bezogen auf das Gesamtgewicht des PMMI-Copolymers, und eine Säurezahl, bestimmt nach DIN 53240-1:2013-06, von 15 bis 50 mg KOH/g aufweist.

3. Zusammensetzung, enthaltend
A) aromatisches Polycarbonat,
B) Talk,
C) PMMI-Copolymer und
D) optional weitere Additive.

4. Zusammensetzung nach Anspruch 3, wobei die Zusammensetzung
A) mindestens 60 Gew.-% aromatisches Polycarbonat,
B) 5 bis 35 Gew.-% Talk,
C) 0,1 bis 8 Gew.-% PMMI-Copolymer und
D) optional weitere Additive
enthält.

5. Zusammensetzung nach Anspruch 3 oder 4, wobei die Zusammensetzung
A) mindestens 68 Gew.-% aromatisches Polycarbonat,
B) 10 bis 30 Gew.-% Talk,
C) 0,2 bis 6 Gew.-% PMMI-Copolymer und
D) optional weitere Additive
enthält.

6. Zusammensetzung nach einem der Ansprüche 3 bis 5, bestehend aus
A) mindestens 68 Gew.-% aromatischem Polycarbonat,
B) 10 bis 30 Gew.-% Talk,
C) 0,2 bis 6 Gew.-% PMMI-Copolymer und
D) optional ein oder mehreren weiteren Additiven, ausgewählt aus der Gruppe, bestehend aus Flammschutzmitteln, Antitropfmitteln, Schlagzähmodifikatoren, von Komponente B verschiedenen Füllstoffen, Antistatika, Farbmitteln, Pigmenten, Ruß, Gleit- und/oder Entformungsmitteln, Thermostabilisatoren, Blendpartner, Verträglichkeitsvermittlern, UV-Absorbern und/oder IR-Absorbern.

7. Zusammensetzung nach einem der Ansprüche 3 bis 6, wobei die Zusammensetzung mindestens 1,5 Gew.-% PMMI-Copolymer enthält, bezogen auf die Gesamtzusammensetzung.

8. Zusammensetzung nach einem der Ansprüche 3 bis 7, wobei die Zusammensetzung 15 bis 25 Gew.-% Talk und mindestens 2 Gew.-% PMMI-Copolymer enthält.

9. Zusammensetzung nach einem der Ansprüche 3 bis 8 oder Verwendung nach Anspruch 1, wobei das PMMI-Copolymer Methylmathacrylat-Einheiten, Methylmethacrylimid-Einheiten, Methylmethacrylsäure-Einheiten und Methylmethacrylanhydrid-Einheiten aufweist.

10. Zusammensetzung nach einem der Ansprüche 3 bis 9 oder Verwendung nach Anspruch 1 oder 9, wobei der Anteil an Methylmethacrylimid-Einheiten mindestens 30 Gew.-%, der Anteil an Methylmathacrylat-Einheiten 3 bis 65 Gew.-% und der Anteil an Methylmethacrylsäure- und Methylmethacrylanhydrid-Einheiten in Summe bis zu 15 Gew.-% beträgt, jeweils bezogen auf das Gesamtgewicht des in der Zusammensetzung enthaltenen PMMI-Copolymers.

11. Zusammensetzung nach einem der Ansprüche 3 bis 10 oder Verwendung nach einem der Ansprüche 1, 9 oder 10, wobei die Säurezahl des PMMI-Copolymers, bestimmt nach DIN 53240-1:2013-06, 15 bis 50 mg KOH/g beträgt.

12. Zusammensetzung nach einem der Ansprüche 3 bis 11 oder Verwendung nach einem der Ansprüche 1, 9, 10 oder 11, wobei der Anteil an Talk 15 bis 25 Gew.-%, bezogen auf die Gesamtzusammensetzung, und das Verhältnis PMMI-Copolymer zu Talk 0,15 bis 0,6 beträgt.

13. Zusammensetzung nach einem der Ansprüche 3 bis 12 oder Verwendung nach einem der Ansprüche 1 oder 9 bis 12, wobei der der Anteil PMMI-Copolymer in der fertigen Zusammensetzung 2 bis 6 Gew.-% beträgt.

14. Formteil aus einer Zusammensetzung nach einem der Ansprüche 3 bis 12.

15. Formteil nach Anspruch 14, wobei das Formteil eine Wärmesenke für elektronische Bauelemente, ein Gehäuse oder Teil eines Gehäuses aus dem E/E-Bereich ist.

## Claims

1. Use of at least one polymethacrylmethylimide copolymer (PMMI copolymer) for reducing the decrease in molecular weight of aromatic polycarbonate in talc-containing polycarbonate compositions on compounding.

2. Use according to Claim 1, wherein the PMMI copolymer has 3% to 65% by weight of methyl methacrylate units, at least 30% by weight of methylmethacrylimide units, a total of up to 15% by weight of methylmethacrylic acid units and methylmethacrylic anhydride units, based in each case on the total weight of the PMMI copolymer, and an acid number, determined according to DIN 53240-1:2013-06, of 15 to 50 mg KOH/g.

3. Composition comprising
A) aromatic polycarbonate,
B) talc,
C) PMMI copolymer and
D) optionally further additives.

4. Composition according to Claim 3, wherein the composition contains
A) at least 60% by weight of aromatic polycarbonate,
B) 5% to 35% by weight of talc,
C) 0.1% to 8% by weight of PMMI copolymer and
D) optionally further additives.

5. Composition according to Claim 3 or 4, wherein the composition contains
A) at least 68% by weight of aromatic polycarbonate,
B) 10% to 30% by weight of talc,
C) 0.2% to 6% by weight of PMMI copolymer and
D) optionally further additives.

6. Composition according to any of Claims 3 to 5, consisting of
A) at least 68% by weight of aromatic polycarbonate,
B) 10% to 30% by weight of talc,
C) 0.2% to 6% by weight of PMMI copolymer and
D) optionally one or more further additives selected from the group consisting of flame retardants, anti-dripping agents, impact modifiers, fillers other than component B, antistats, colourants, pigments, carbon black, lubricants and/or demoulding agents, thermal stabilizers, blending partners, compatibilizers, UV absorbers and/or IR absorbers.

7. Composition according to any of Claims 3 to 6, wherein the composition contains at least 1.5% by weight of PMMI copolymer, based on the overall composition.

8. Composition according to any of Claims 3 to 7, wherein the composition contains 15% to 25% by weight of talc and at least 2% by weight of PMMI copolymer.

9. Composition according to any of Claims 3 to 8 or use according to Claim 1, wherein the PMMI copolymer has methyl methacrylate units, methylmethacrylimide units, methylmethacrylic acid units and methylmethacrylic anhydride units.

10. Composition according to any of Claims 3 to 9 or use according to Claim 1 or 9, wherein the proportion of methylmethacrylimide units is at least 30% by weight, the proportion of methyl methacrylate units is 3% to 65% by weight and the proportion of methylmethacrylic acid and methylmethacrylic anhydride units is up to 15% by weight in total, based in each case on the total weight of the PMMI copolymer present in the composition.

11. Composition according to any of Claims 3 to 10 or use according to any of Claims 1, 9 and 10, wherein the acid number of the PMMI copolymer, determined to DIN 53240-1:2013-06, is 15 to 50 mg KOH/g.

12. Composition according to any of Claims 3 to 11 or use according to any of Claims 1, 9, 10 and 11, wherein the proportion of talc is 15% to 25% by weight, based on the overall composition, and the ratio of PMMI copolymer to talc is 0.15 to 0.6.

13. Composition according to any of Claims 3 to 12 or use according to any of Claims 1 and 9 to 12, wherein the proportion of PMMI copolymer in the finished composition is 2% to 6% by weight.

14. Moulding made of a composition according to any of Claims 3 to 12.

15. Moulding according to Claim 14, wherein the moulding is a heat sink for electronic components, a housing or part of a housing from the electrics and electronics sector.

## Revendications

1. Utilisation d'au moins un copolymère de polyméthacrylméthylimide (copolymère PMMI) pour la réduction de la diminution du poids moléculaire de polycarbonate aromatique dans des compositions de polycarbonate contenant du talc lors du mélange.

2. Utilisation selon la revendication 1, dans laquelle le copolymère de PMMI comprend 3 à 65 % en poids d'unités méthacrylate de méthyle, au moins 30 % en poids d'unités méthylméthacrylimide, au total jusqu'à 15 % en poids d'unités acide méthylméthacrylique et d'unités anhydride méthylméthacrylique, à chaque fois par rapport au poids total du copolymère de PMMI, et un indice d'acidité, déterminé selon DIN 53240-1:2013-06, de 15 à 50 mg KOH/g.

3. Composition, contenant :
A) un polycarbonate aromatique,
B) du talc,
C) un copolymère de PMMI et
D) éventuellement des additifs supplémentaires.

4. Composition selon la revendication 3, dans laquelle la composition contient :
A) au moins 60 % en poids de polycarbonate aromatique,
B) 5 à 35 % en poids de talc,
C) 0,1 à 8 % en poids de copolymère de PMMI et
D) éventuellement des additifs supplémentaires.

5. Composition selon la revendication 3 ou 4, dans laquelle la composition contient :
A) au moins 68 % en poids de polycarbonate aromatique,
B) 10 à 30 % en poids de talc,
C) 0,2 à 6 % en poids de copolymère de PMMI et
D) éventuellement des additifs supplémentaires.

6. Composition selon l'une quelconque des revendications 3 à 5, constituée par :
A) au moins 68 % en poids de polycarbonate aromatique,
B) 10 à 30 % en poids de talc,
C) 0,2 à 6 % en poids de copolymère de PMMI et
D) éventuellement un ou plusieurs additifs supplémentaires, choisis dans le groupe constitué par les agents ignifuges, les agents anti-gouttes, les modificateurs de la résistance aux impacts, les charges différentes du composant B, les antistatiques, les colorants, les pigments, le noir de carbone, les agents lubrifiants et/ou de démoulage, les thermostabilisateurs, les partenaires de mélange, les compatibilisateurs, les absorbeurs UV et/ou les absorbeurs IR.

7. Composition selon l'une quelconque des revendications 3 à 6, dans laquelle la composition contient au moins 1,5 % en poids de copolymère de PMMI, par rapport à la composition totale.

8. Composition selon l'une quelconque des revendications 3 à 7, dans laquelle la composition contient 15 à 25 % en poids de talc et au moins 2 % en poids de copolymère de PMMI.

9. Composition selon l'une quelconque des revendications 3 à 8 ou utilisation selon la revendication 1, dans laquelle le copolymère de PMMI comprend des unités méthacrylate de méthyle, des unités méthylméthacrylimide, des unités acide méthylméthacrylique et des unités anhydride méthylméthacrylique.

10. Composition selon l'une quelconque des revendications 3 à 9 ou utilisation selon la revendication 1 ou 9, dans laquelle la proportion d'unités méthylméthacrylimide est d'au moins 30 % en poids, la proportion d'unités méthacrylate de méthyle est de 3 à 65 % en poids et la proportion d'unités acide méthylméthacrylique et anhydride méthylméthacrylique est au total de jusqu'à 15 % en poids, à chaque fois par rapport au poids total du copolymère de PMMI contenu dans la composition.

11. Composition selon l'une quelconque des revendications 3 à 10 ou utilisation selon l'une quelconque des revendications 1, 9 ou 10, dans laquelle l'indice d'acidité du copolymère de PMMI, déterminé selon DIN 53240-1:2013-06, est de 15 à 50 mg KOH/g.

12. Composition selon l'une quelconque des revendications 3 à 11 ou utilisation selon l'une quelconque des revendications 1, 9, 10 ou 11, dans laquelle la proportion de talc est de 15 à 25 % en poids, par rapport à la composition totale, et le rapport du copolymère de PMMI au talc est de 0,15 à 0, 6.

13. Composition selon l'une quelconque des revendications 3 à 12 ou utilisation selon l'une quelconque des revendications 1 ou 9 à 12, dans laquelle la proportion du copolymère de PMMI dans la composition finie est de 2 à 6 % en poids.

14. Pièce moulée en une composition selon l'une quelconque des revendications 3 à 12.

15. Pièce moulée selon la revendication 14, dans laquelle la pièce moulée est un puit thermique pour des composants électroniques, un boîtier ou une partie d'un boîtier dans le domaine E/E.
